(19) Europäisches Patentamt / European Patent Office / Office européen des brevets

(11) **EP 2 767 860 A1**

(12) **DEMANDE DE BREVET EUROPEEN**

(43) Date de publication:
**20.08.2014 Bulletin 2014/34**

(51) Int Cl.:
*G02B 27/28* (2006.01)   *G01J 3/02* (2006.01)

(21) Numéro de dépôt: **14154468.4**

(22) Date de dépôt: **10.02.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **15.02.2013 FR 1300332**

(71) Demandeur: **Thales**
**92200 Neuilly Sur Seine (FR)**

(72) Inventeur: **Tetaz, Nicolas**
**06400 Cannes (FR)**

(74) Mandataire: **Hnich-Gasri, Naïma et al**
**Marks & Clerk France**
**Immeuble Visium**
**22, avenue Aristide Briand**
**94117 Arcueil Cedex (FR)**

(54) **Dispositif de dépolarisation amelioré**

(57) L'invention propose un dispositif de dépolarisation (100) pour réduire le degré de polarisation d'un faisceau incident. Le dispositif comprend un ensemble de prismes (11, 12, 13, 14) comprenant un nombre pair de prismes au moins égal à 4, les prismes étant agencés le long d'un axe optique principal. Chaque prisme est constitué de deux lames prismatiques élémentaires (111, 112, 121, 122, 131, 132, 141, 142) de matériaux biréfringents accolées dont les axes optiques sont orthogonaux entre eux, de manière à transformer le faisceau de lumière non polarisée qui le traverse en deux faisceaux de directions différentes et de polarisations linéaires orthogonales entre elles. Chaque prisme a un angle au sommet $\alpha$ et un angle de rotation $\beta$ prédéfini par rapport à l'axe optique principal. L'angle au sommet du premier prisme, l'angle au sommet du deuxième prisme, l'angle au sommet du troisième prisme et l'angle au sommet du quatrième prisme sont choisis de manière à optimiser les performances du dispositif de dépolarisation.

FIG.12

# Description

## Domaine technique

La présente invention concerne de manière générale les dispositifs de dépolarisation, et en particulier un dispositif de dépolarisation pour spectromètre.

Les dispositifs de dépolarisation ou dépolariseurs (ou fenêtre dépolarisante) sont utilisés pour transformer une lumière incidente totalement ou partiellement polarisée en une lumière très peu polarisée. Les dépolariseurs sont généralement utilisés dans les spectromètres et plus particulièrement dans les spectromètres d'observation de la Terre qui sont très sensibles à la polarisation. Dans de tels appareils, la lumière émise ou réfléchie par la Terre est très polarisée, et cette polarisation est très variable. La seule solution pour réduire les erreurs radiométriques est alors d'utiliser un dépolariseur en entrée de l'instrument. Les instruments MERIS,OMI, Sentinel-4, Sentinel-5, Microcarb sont des exemples d'instruments équipés de dépolariseurs.

Les dépolariseurs connus sont constitués d'assemblages de prismes de cristal biréfringent. Il existe deux types de dépolariseurs : le dépolariseur Meris et le dépolariseur appelé double-babinet (« dual-babinet » en langue anglo-saxonne). Bien que le dépolariseur Meris et le double babinet reposent sur le même principe de fonctionnement, le dépolariseur Meris est plus sensible à la longueur d'onde, et globalement moins performant que le double-babinet.

Avec les dépolariseurs actuellement disponibles, les paramètres d'optimisation ont des plages de variations limitées par les problèmes de volume instrument et de géolocalisation. Il est par conséquent difficile, voire impossible, de définir un dépolariseur ayant une efficacité de dépolarisation suffisante. Ceci est encore plus vrai pour les dépolariseurs travaillant sur des larges bandes spectrales.

Par ailleurs, si les dépolariseurs connus réduisent le degré de polarisation d'une lumière incidente polarisée, ils fonctionnent mal sur des grands domaines de longueur d'onde, ou pour des angles d'incidences élevés. Ils ont en outre un impact important sur la connaissance de la ligne de visée des instruments.

## Définition générale de l'invention

L'invention vient améliorer la situation en proposant un dispositif de dépolarisation pour réduire le degré de polarisation d'un faisceau incident. Il comprend un ensemble de prismes comprenant un nombre pair de prismes au moins égal à 4, les prismes étant agencés le long d'un axe optique principal, chaque prisme étant constitué de deux lames prismatiques élémentaires de matériaux biréfringents accolées dont les axes optiques sont orthogonaux entre eux, de manière à transformer le faisceau de lumière non polarisée qui le traverse en deux faisceaux de directions différentes et de polarisations linéaires orthogonales entre elles. Chaque prisme a un angle au sommet $\alpha$ et un angle de rotation $\beta$ prédéfini par rapport à l'axe optique principal. L'angle au sommet du premier prisme, l'angle au sommet du deuxième prisme, l'angle au sommet du troisième prisme et l'angle au sommet du quatrième prisme sont choisis de manière à optimiser les performances du dispositif de dépolarisation.

Selon une caractéristique de l'invention, l'angle au sommet du premier prisme est choisi de manière à minimiser l'erreur de pointage.

Selon une autre caractéristique de l'invention, l'angle au sommet du deuxième prisme est choisi de manière à optimiser l'efficacité de dépolarisation.

En complément, l'angle au sommet du troisième prisme et l'angle au sommet du quatrième prisme sont choisis de manière à optimiser l'efficacité de dépolarisation et la taille de la tache image formée à la sortie du dispositif de dépolarisation.

Selon un autre aspect de l'invention, les angles de rotation du premier prisme, du deuxième prisme et du troisième prisme sont choisis de manière à optimiser les performances de l'efficacité de dépolarisation.

Dans une forme de réalisation de l'invention, le dispositif de dépolarisation comprend 4 prismes et prisme est un prisme de babinet.

Dans une autre forme de réalisation de l'invention, le dispositif de dépolarisation comprend 4 prismes et chaque prisme est un prisme de Wollastone.

L'angle $\alpha 1$ au sommet du premier prisme peut avantageusement être choisi égal à l'angle $\alpha 2$ au sommet du deuxième prisme, tandis que l'angle $\alpha 3$ au sommet du troisième prisme peut être choisi égal à l'angle $\alpha 4$ au sommet du quatrième prisme.

Selon une autre caractéristique de l'invention, le deuxième prisme peut présenter un angle de rotation de + 45° autour de l'axe optique principal tandis que le quatrième prisme peut présenter une rotation de -45° autour de l'axe optique principal.

En variante, le deuxième prisme peut présenter un angle de rotation de - 45° autour de l'axe optique principal tandis que le quatrième prisme peut présenter une rotation de +45° autour de l'axe optique principal.

Une puissance non nulle peut en outre être appliquée à certains au moins des prismes du dispositif de dépolarisation.

Le dépolariseur selon l'invention permet ainsi de réduire fortement le degré de polarisation de la lumière, tout en fonctionnant sur une large bande de longueur d'onde. Par ailleurs, il perturbe très peu la connaissance de la ligne de visée.

Le dépolariseur selon l'invention utilise 4 prismes de babinet ou de Wollaston, ce qui permet d'augmenter le nombre de degrés de liberté indépendants et d'optimiser le dépolariseur. En particulier, il permet d'appliquer la contrainte d'erreur de pointage au premier prisme, tandis que les trois autres prismes sont utilisés pour l'amélioration de la dépolarisation.

En outre, il permet d'augmenter la qualité de la dépolarisation tout en conservant une erreur de pointage faible, et ce sur une large plage de longueur d'onde.

**Brève description des dessins**

D'autres caractéristiques et avantages de l'invention apparaîtront à l'aide de la description qui suit et des figures des dessins annexés dans lesquels :

- La figure 1 représente un double-babinet selon l'art antérieur ;
- La figure 2 est un schéma illustrant l'état de polarisation pour différents rayons en sortie d'une lame dépolarisante ;
- La figure 3 illustre l'effet de séparation des faisceaux par un prisme de babinet ;
- La figure 4 est un schéma montrant la répartition de l'énergie en fonction de la polarisation incidente ;
- La figure 5 illustre l'effet de séparation des faisceaux par deux prismes de babinet ;
- La figure 6 montre quatre tâches images après un double-babinet ;
- La figure 7 est un schéma d'un spectromètre comportant un dépolariseur de babinet ;
- La figure 8 est un diagramme représentant l'évolution du taux de polarisation après un double-babinet, en fonction du diamètre du dépolariseur ;
- La figure 9 est un diagramme représentant l'évolution du taux de polarisation après un double-babinet, en fonction de l'angle $\alpha$ des prismes du double-babinet ;
- La figure 10 est un diagramme représentant l'évolution de l'erreur de pointage en fonction de l'angle $\alpha$ des prismes du double-babinet ;
- La figure 11 représente un double-babinet ainsi que la puissance et les taches obtenues avec ce double-babinet ;
- La figure 12 est un schéma représentant un dépolariseur à 4 prismes, selon l'invention ;
- La figure 13 représente la structure d'un prisme de babinet utilisé dans un dépolariseur selon l'invention ;
- La figure 14 représente la structure d'un prisme de Wollaston utilisé dans un dépolariseur selon l'invention ;
- La figure 15 illustre l'influence des paramètres du tétra-babinet sur les performances du dépolariseur ;
- La figure 16 est un schéma du dépolariseur selon l'invention, montrant l'influence des paramètres d'angles des prismes sur les performances du dépolariseur ;
- La figure 17 illustre le rayon de la PSF de la tache image pour une configuration particulière du dépolariseur ; et
- La figure 18 est un diagramme montrant le degré de polarisation pour un faisceau optique polarisé traversant différents types de dépolariseur.

Les dessins comprennent, pour l'essentiel, des éléments de caractère certain. Ils pourront donc non seulement servir à mieux faire comprendre la description, mais aussi contribuer à la définition de l'invention, le cas échéant.

**Description détaillée**

L'invention s'appuie sur une analyse fine de phénomènes en jeu dans les dépolariseurs existants et en particulier du double-babinet. Cette analyse porte non seulement sur le fonctionnement du double-babinet mais aussi l'identification de ses limites. La description qui suit mentionne tout d'abord le résultat de cette analyse. L'homme du métier comprendra que cette analyse même est le fruit d'importants travaux. Les éléments de cette analyse sont mentionnés ici pour faciliter la compréhension de l'invention et de ses avantages.

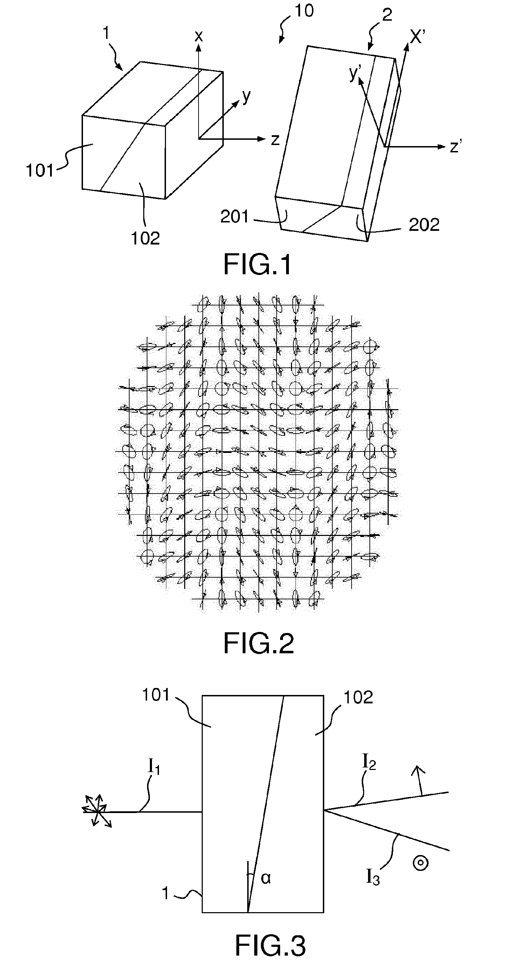

La figure 1 représente un dépolariseur de type double-babinet 10, selon l'art antérieur. Une fenêtre dépolarisante du type double-Babinet est constituée de l'association de deux lames 1 et 2 comprenant chacune deux prismes de cristal biréfringent collés (101, 102) et (201, 202), en quartz. Chaque lame 1 et 2 est orientée à 45 degrés. La biréfringence du quartz est à l'origine de l'effet dépolarisant. Pour une polarisation incidente 100% linéaire, chaque rayon traversant le double Babinet, ressort avec une polarisation fonction de la position dans la pupille. La polarisation moyenne résultante est pseudo-dépolarisée comme représenté sur la figure 2.

Dans un double-babinet classique, l'effet de brouillage croît avec l'angle $\alpha$ des prismes de quartz et la surface du double Babinet utilisée. Plus l'angle $\alpha$ des prismes est grand, plus le double-babinet est efficace. Cet effet de dépolarisation est accompagné d'un partage du faisceau. Un babinet seul sépare le faisceau incident I1 (de polarisation aléatoire) en deux faisceaux de polarisations linéaires et perpendiculaires I2 et I3, comme représenté sur la figure 3.

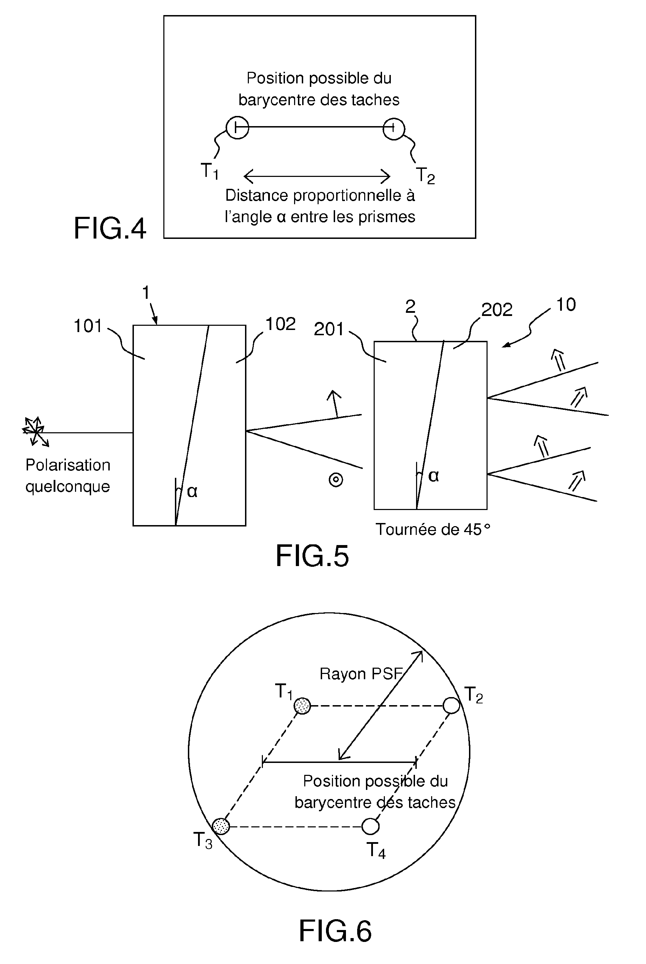

Lorsque l'on place une lentille parfaite après le dépolariseur, on observe à son foyer deux tâches images T1 et T2 correspondant chacune à une polarisation linéaire comme représenté sur la figure 4. La répartition d'énergie entre les deux tâches varie en fonction de la polarisation incidente. Le barycentre des tâches se déplace donc sur le segment de droite [T1 T2] entre les deux taches.

Un double babinet 10 est constitué de 2 prismes de Babinet successifs. Il sépare donc un faisceau incident en quatre spots élémentaires. La séparation est proportionnelle à l'angle des prismes en quartz comme illustré sur les figures 5 et 6. La figure 5 illustre l'effet de séparation des faisceaux par deux prismes de babinet. La figure 6 montre quatre tâches images T1, T2, T3 et T4 après un double-babinet, représentées par des points. Les énergies des deux points de droite sont toujours égales, de même que celle des deux points de gauche. Le barycentre se déplace donc sur un segment de droite. Le diamètre de la tache image globale (ou PSF, acronyme pour « Point Spread Function ») a pour rayon le rayon du cercle circonscrit à la figure formée par les quatre tâches élémentaires. La PSF désigne la fonction d'étalement d'un point source à travers une optique. Plus précisément, elle correspond à l'image d'un point source à l'infini observé au foyer d'une optique. Plus la tache image est petite, plus l'image produite par l'instrument est de qualité. Inversement, plus on augmente le diamètre de la PSF, plus la qualité image est mauvaise (l'image est dite « floue »).

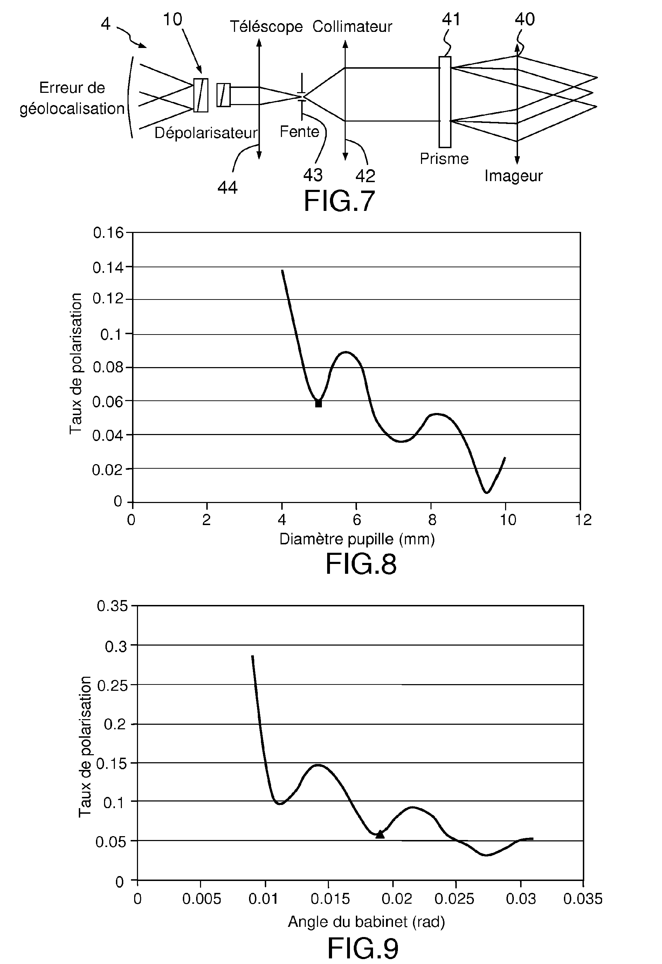

La figure 7 représente un spectromètre 4 incluant un imageur 40, un prisme 41, un collimateur 42, une fente 43, un télescope 44, et un dépolariseur 10. Dans un spectromètre, la fenêtre dépolarisante est positionnée en amont de l'instrument. La projection de la fente sur la Terre dépend de l'orientation de la polarisation du faisceau incident comme représenté sur la figure 7 qui représente un spectromètre. L'effet de séparation des faisceaux dégrade donc la précision de connaissance de la ligne de visée (géolocalisation). Sur la figure 7, on constate que l'image de la fente sur Terre à travers le télescope et le dépolariseur est quadruple, ce qui a un effet sur la connaissance de la ligne de visée (géolocalisation) et sur la qualité de l'image de la fente sur Terre (PSF). Par conséquent, plus l'angle $\alpha$ des prismes est grand, plus la PSF et la géolocalisation sont dégradées.

L'erreur de pointage, ou géolocalisation, désigne le point de la terre imagé par un spectromètre. Les spectromètres sont notamment utilisés dans certaines applications pour déterminer le spectre émis (ou réfléchi) par un point précis de la terre. A partir de ce spectre, il est possible de déterminer les différents éléments chimiques de l'atmosphère à ce point précis du globe. Par exemple, de nombreuses études sont menées à l'aide de spectromètres pour déterminer la concentration en $CO_2$ de l'atmosphère, et pour connaître précisément les zones sur Terre où le $CO_2$ est fortement présent (source de pollution). Connaissant la position d'un satellite dans l'espace (repère par rapport à des étoiles), et connaissant précisément l'axe de visée (encore appelé ligne de visée) du spectromètre, c'est-à-dire la direction dans laquelle « regarde » le spectromètre, il est possible de déterminer précisément le point de la terre imagé par le spectromètre (géolocalisation). Les spécifications sur la connaissance de l'axe de visée du spectromètre sont donc très sévères. Le dépolariseur perturbe fortement la connaissance de l'axe de visée de l'instrument, car en fonction de la polarisation de la scène le satellite ne « regarde » pas au même endroit.

Pour obtenir la meilleure dépolarisation possible, il est possible soit d'augmenter la surface utile du double-babinet (c'est-à-dire l'ouverture de l'instrument) comme illustré sur la figure 8, soit d'augmenter l'angle $\alpha$ des prismes comme illustré sur la figure 9. Si ces deux approches peuvent être efficaces, elles atteignent toutefois leurs limites assez rapidement. En effet, pour augmenter le diamètre utile du double-babinet, il est nécessaire d'augmenter la pupille de l'instrument, donc son volume et son poids. Avec un double-babinet classique, il n'est ainsi pas possible d'optimiser à la fois la qualité du dépolariseur et la taille globale de l'instrument.

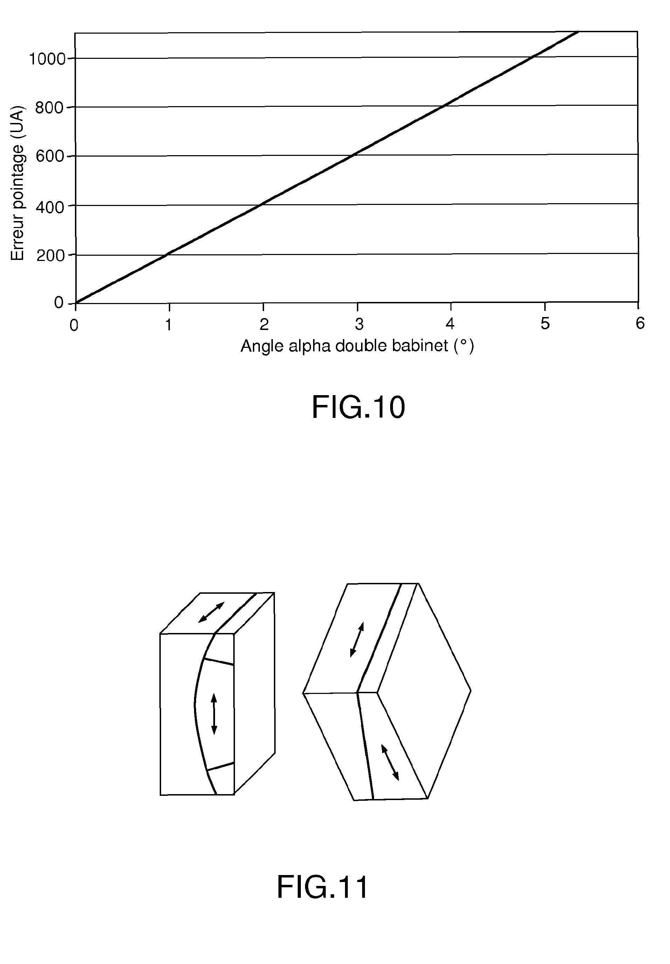

Par ailleurs, l'augmentation de l'angle des prismes a un impact direct sur la variation de la position du barycentre des 4 taches élémentaires, c'est-à-dire sur l'erreur de pointage (comme représenté sur la figure 11). Là encore, les contraintes fixées en termes d'erreur de pointage limitent rapidement l'augmentation possible de l'angle $\alpha$. En outre, l'augmentation de l'angle $\alpha$ des prismes dégrade aussi la qualité image de la projection de la fente au sol et l'erreur de pointage limite l'augmentation de l'angle $\alpha$ bien avant d'atteindre la PSF maximale autorisée.

Une autre solution connue pour réduire l'erreur de pointage est de prévoir un rayon de courbure cylindrique sur le premier babinet. Il est alors possible de fusionner les 4 taches élémentaires deux par deux. La position du barycentre varie alors moins en fonction de la polarisation incidente comme représenté sur la figure 11. Cette approche permet de remonter la limite sur l'angle $\alpha$ maximum et d'obtenir une meilleure dépolarisation. Cependant, le fait de remplacer une face tiltée par un rayon de courbure réduit la qualité de dépolarisation. Cette approche peut présenter certains avantages, notamment quand les angles d'incidences sur le babinet sont importants, mais de manière insuffisante.

Par conséquent, avec ces solutions connues, les paramètres d'optimisation ont des plages de variations limitées par les problèmes de volume instrument et de géolocalisation de sorte qu'il est difficile de définir un dépolariseur ayant une efficacité de dépolarisation suffisante. Ceci est encore plus vrai pour les dépolariseurs travaillant sur des larges bandes spectrales.

Une autre approche envisageable pourrait reposer sur une augmentation de la surface du losange formé par les 4 taches élémentaires sur la figure 6 pour augmenter la puissance de dépolarisation. Toutefois, une telle solution aurait pour effet d'augmenter le déplacement du barycentre et donc l'erreur de pointage.

L'invention remédie à ces inconvénients en proposant un dépolariseur amélioré comportant au moins 4 prismes, permettant d'augmenter la puissance de dépolarisation tout en conservant une erreur de géolocalisation faible. La présente description porte non seulement une nouvelle structure de dépolariseur mais aussi sur ses principes de fonctionnement.

Comme cela est bien connu, un dispositif optique n'a d'intérêt que si les phénomènes en jeu et l'influence des paramètres structurels sur les performances finales sont bien compris. Or la modélisation des effets dus à la biréfringence sur la polarisation sont complexes. Il est possible d'utiliser des modèles mathématiques pour simuler la polarisation d'un rayon traversant un double-babinet. Cependant, à partir des équations mathématiques seules, il est difficile de bien comprendre l'influence des différents paramètres (notamment les angles $\alpha$) sur

la polarisation finale et la forme des taches images au foyer d'une lentille. Pour l'analyse du dépolariseur selon l'invention, l'inventeur a utilisé conjointement un modèle mathématique sur Matlab et un modèle sous CodeV. Les deux modèles ont été corrélés pour simuler la polarisation et les taches images des prismes du dépolariseur selon l'invention, sans qu'il soit nécessaire de décrire au préalable le système par des équations complexes.

La suite de la description sera faite en référence à un dépolariseur à 4 prismes, à titre d'exemple non limitatif.

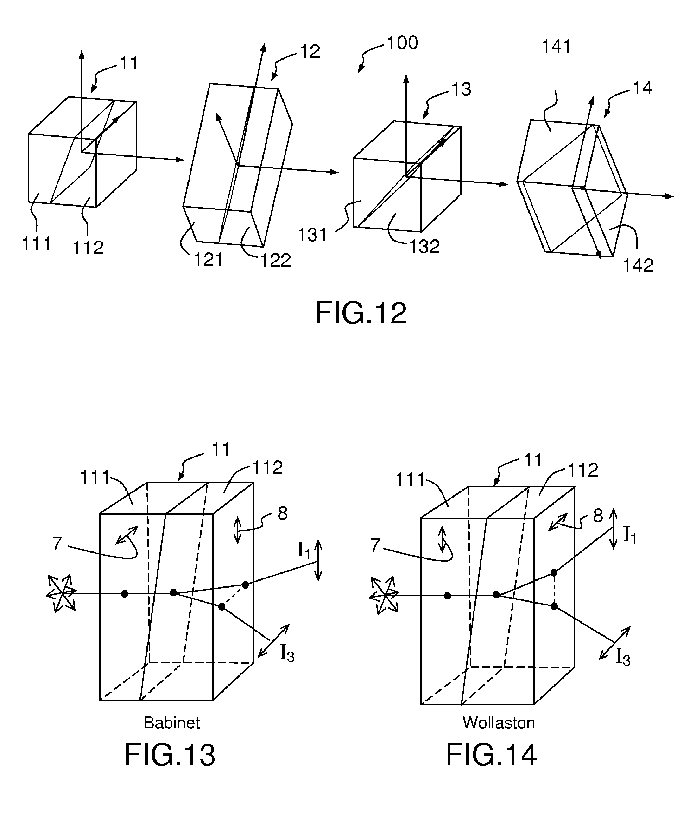

La figure 12 représente un dépolariseur 100 selon une forme de réalisation de l'invention configuré pour transformer une lumière incidente totalement ou partiellement polarisée, en une lumière très peu polarisée.

Dans une forme de réalisation de l'invention, le dépolariseur 100 est un tétra-babinet comprenant 4 prismes de babinet 11, 12, 13 et 14. Chaque prisme de babinet 11, 12, 13, 14 permet de transformer un faisceau de lumière non polarisée I1 en deux faisceaux de directions différentes I2 et I3, et de polarisations linéaires orthogonales entre elles. Comme représenté sur la figure 12, chaque prisme 11, 12, 13 et 14 du dépolariseur selon l'invention est constitué de deux lames prismatiques élémentaires, respectivement : (111, 112), (121, 122), (131, 132), (141, 142). Les prismes élémentaires sont constitués de matériaux biréfringents accolés (par exemple en quartz, calcite,...) dont les axes optiques (désignés par les références 7 et 8) sont orthogonaux entre eux. L'écart angulaire entre les deux faisceaux sortants est déterminé par l'angle $\alpha$ au sommet des prismes élémentaires, et par la longueur d'onde de la lumière. Chaque prisme 11, 12, 13 et 14 a un angle au sommet $\alpha$ et un angle de rotation $\beta$ prédéfini par rapport à l'axe optique principal.

En variante, chaque prisme 11, 12, 13, 14 du dépolariseur selon l'invention peut être un prisme de Wollaston. Dans cette forme de réalisation, le dépolariseur sera appelé « tétra-wollaston ». Comme représenté sur la figure 14, un prisme de Wollaston a la même structure qu'un prisme de Babinet, mais la direction des axes optiques des cristaux (désignés également par les références 7 et 8) est inversée : l'axe optique 7 est horizontal dans le premier prisme d'un babinet tandis qu'il est vertical dans un prisme de Wollaston. Un tétra-wollaston selon l'invention fonctionne de la même manière qu'un tétra-babinet, et avec les mêmes performances. La suite de la description sera faite en référence à un tétra-babinet à titre d'exemple non limitatif.

De manière inattendue, l'inventeur a trouvé que l'utilisation d'un nombre pair de prismes de babinet ou de Wollaston au moins égal à 4 a pour effet de découpler les trois performances relatives à l'efficacité de dépolarisation, à l'erreur de géolocalisation et à la taille de la tâche image. Chaque prisme 11, 12, 13 et 14 peut être affecté à un rôle principal. En particulier, dans la forme de réalisation de tetra-babinet, l'angle au sommet du premier prisme $\alpha$1 détermine principalement l'erreur de géolocalisation (et l'efficacité de dépolarisation dans une moindre mesure), l'angle $\alpha$2 du second prisme a un impact léger sur l'efficacité de dépolarisation, tandis que les angles $\alpha$3 et $\alpha$4 des troisième et quatrième prismes déterminent l'efficacité de dépolarisation et la taille de la tache image. L'utilisation d'un double-babinet classique ne permet pas un tel découplage des performances de dépolarisation, de l'erreur de géolocalisation et de la taille de la tache image. Dans un double-babinet classique, seul l'angle au sommet des prismes constituant le premier babinet détermine directement l'efficacité de dépolarisation, la taille de la tache image et l'erreur de pointage. L'angle au sommet du second prisme quant à lui a un impact sur l'efficacité de dépolarisation et la taille de la tache image.

Le dépolariseur selon l'invention permet ainsi, en optimisant l'angle au sommet des prismes $\alpha$, de répondre aux contraintes de taille de la tâche image et d'erreur de géolocalisation, tout en optimisant l'efficacité de dépolarisation.

L'augmentation des angles $\alpha$ entraîne une augmentation de la taille de la tache image. L'augmentation de la surface couverte par la tâche image va de pair avec une augmentation de l'efficacité de dépolarisation.

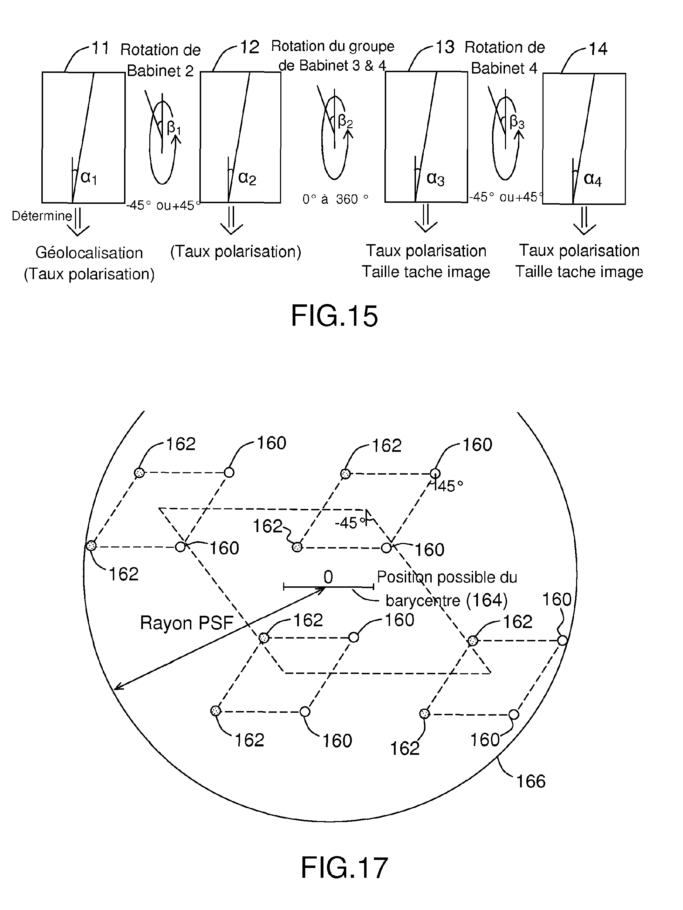

La figure 15 illustre les différents paramètres ajustables du dépolariseur 100 selon l'invention et l'impact de ces paramètres sur les performances du dépolariseur.

Comme représenté sur la figure 15, l'angle $\alpha$3 au sommet du troisième prisme de babinet 13 et l'angle $\alpha$4 au sommet du quatrième prisme de babinet 14 peuvent donc être augmentés jusqu'à atteindre la taille de PSF maximale acceptable.

L'angle $\alpha$1 au sommet du premier prisme de babinet 11 peut être augmenté jusqu'à atteindre l'erreur de géolocalisation maximale acceptable.

A rayon de PSF donné, l'efficacité de dépolarisation est maximale pour une surface couverte par la tache image maximale.

L'angle $\alpha$2 au sommet du deuxième prisme de babinet 12, ainsi que les angles de rotation $\beta$1 du premier prisme, $\beta$2 du deuxième prisme et $\beta$3 du troisième prisme sont choisis de manière à augmenter la surface couverte par la tache image et augmenter l'efficacité de dépolarisation.

Avantageusement, le tétra-babinet 100 selon l'invention peut être utilisé pour dépolariser la lumière en entrée d'un spectromètre spatial à large bande spectrale. Bien que l'invention présente certains avantages pour une telle application, elle n'est pas limitée à une utilisation dans un spectromètre spatial à large bande spectrale.

L'utilisation de quatre prismes selon l'invention permet d'augmenter le nombre de degré de liberté et de découpler la fonction des différents prismes. Le premier prisme 11 a ainsi un impact sur l'erreur de ligne de visée, tandis que les trois autres prismes 12, 13, et 14 peuvent être utilisés pour améliorer la dépolarisation sans avoir à respecter la contrainte majeure de l'erreur de pointage.

Avec le tétra-babinet selon l'invention, le gain attendu sur la qualité de dépolarisation est d'un facteur sensiblement égal à 10, par rapport à un double-babinet. Il en résulte une relaxation des fortes contraintes sur le design du réseau de diffraction et sur toute l'optique qui est construite autour. L'utilisation du tétra-babinet selon l'invention permet ainsi un design de spectromètre plus simple, plus sain et plus performant.

En effet, une des contraintes portant sur les spectromètres est une faible sensibilité à la polarisation incidente. Ainsi, quelque soit l'état de polarisation de la scène (linéaire, elliptique, non polarisée,etc...), l'intensité lumineuse arrivant sur les pixels doit être constante. Une telle contrainte peut être satisfaite de deux manières :

- en utilisant des composants optiques (miroir, lentilles, réseau, détecteur) non sensibles à la polarisation, c'est-à-dire qui fonctionnent de la même manière quelque soit la polarisation incidente ;

- en utilisant un composant qui dépolarise complètement la lumière en entrée d'instrument.

En pratique, il est impossible d'obtenir un dépolariseur parfait et des optiques non sensibles à la polarisation. Aussi, pour respecter les spécifications concernant la sensibilité à la polarisation du spectromètre, un équilibre doit être trouvé entre un dépolariseur performant et des optiques peu sensibles à la polarisation.

Le composant le plus critique d'un spectromètre est généralement le réseau. Le réseau doit diffracter la lumière de manière efficace et diffracter la lumière avec la même efficacité quelque soit la polarisation incidente. Il existe différentes architectures de réseau : réseau par réflexion, par transmission, réseau par réflexion immergé dans un prisme, etc.... Or, selon le type de réseau choisi la combinaison optique construite autour du réseau varie fortement en complexité et en encombrement.

Lorsque le dépolariseur a de faibles performances, il convient d'avoir un réseau quasi-insensible à la polarisation, ce qui laisse peu de choix sur le type de réseau utilisable, et donc sur l'architecture optique globale de l'instrument. Par contre, lorsque le dépolariseur est très performant, des réseaux sensibles à la polarisation peuvent être acceptables, ce qui laisse plus de liberté dans le choix du réseau. Il est alors possible de choisir l'architecture de réseau permettant d'avoir l'architecture optique globale la plus simple.

Avantageusement, les angles $\alpha i$ au sommet des 4 prismes 11, 12, 13 et 14 du tétra-babinet 100 selon l'invention, ainsi que la rotation entre les prismes peuvent être choisis de manière à optimiser les performances du tétra-babinet. L'homme du métier comprendra aisément que la représentation schématique du tétra-babinet sur la figure 13 est faite à titre d'exemple non limitatif. En particulier, l'espace entre les babinets, tel que représenté sur les figures, a été choisi de manière arbitraire et n'a pas de signification particulière, et bien entendu le tétra-babinet peut être plus resserré dans certains modes de réalisation de l'invention.

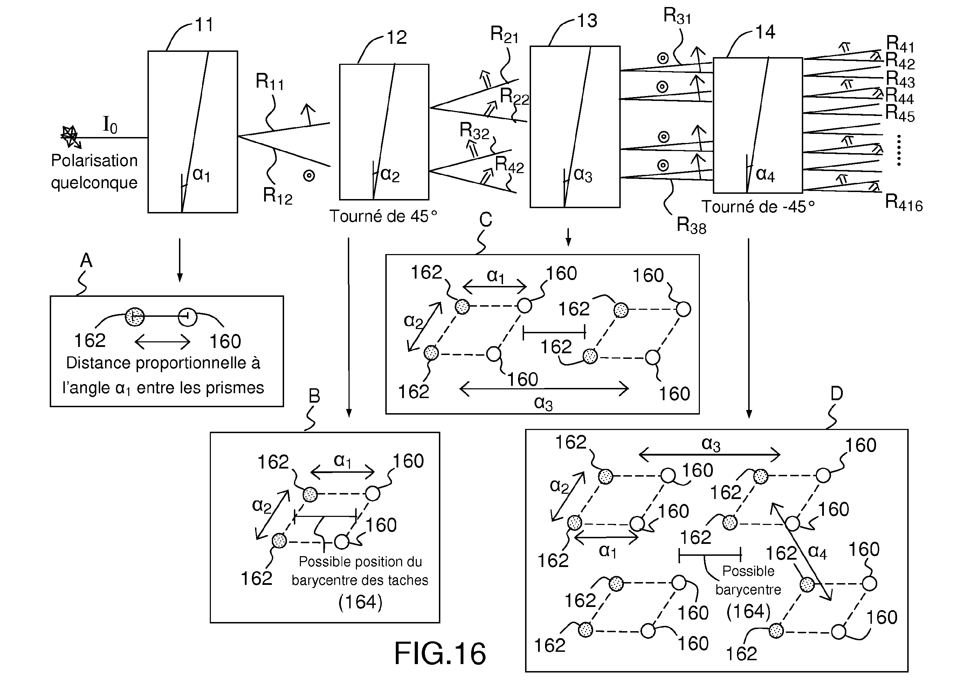

La figure 16 représente de manière schématique le fonctionnement du tétra-babinet 100 selon l'invention.

Comme représenté sur la figure, un rayonnement de polarisation quelconque I0 traverse les quatre prismes de babinet 11, 12, 13 et 14 agencés en cascade. Chaque prisme de babinet sépare un rayon incident Ri en deux rayons de polarisation linéaire et perpendiculaires. On obtient ainsi 4 rayons (R2-1, R2-2, R2-3, R2-4) après la traversée des deux premiers prismes, et 16 rayons résultants (R4-1, ...R4-16) après la traversée des 4 prismes. Au foyer d'une lentille, chaque rayon donne une tâche image. Par conséquent, on obtient 2 tâches après le premier prisme 11, 4 tâches après le deuxième prisme 12, 8 tâches après le troisième prisme 13 et 16 tâches après le quatrième prisme 14.

Sur la figure 16, les taches élémentaires sont représentées après chaque babinet dans les vues détaillées A, B, C et D de la figure 16. Ces vues détaillées permettent de comprendre l'influence de chacun des 4 prismes de babinet du dépolariseur selon l'invention, à partir de l'analyse de la répartition des tâches. Tous les points représentés par une forme ronde grisée, et généralement désignés par la référence 160, correspondent à des tâches de même énergie et aux rayons représentés en traits gris sur la figure 16 (vue principale). De même, les points représentés par une forme ronde noire, et généralement désignés par la référence 162, correspondent à des taches de même énergie et aux rayons représentés en traits noirs sur la vue principale de la figure 16. Les vues détaillées A, B, C et D correspondent à la répartition des taches respectivement après le premier prisme 11, le deuxième prisme 12, le troisième prisme 13 et le quatrième prisme 14. On constate que chaque angle de prisme $\alpha$ a une influence sur une seule des distances entre les points. On remarque aussi que l'énergie est régulièrement répartie entre les taches. Ainsi, lorsque la polarisation incidente varie, le barycentre des taches se déplace sur le segment 164. Or la longueur de ce segment 164 est uniquement proportionnelle à l'angle $\alpha 1$ du premier prisme de babinet, comme indiqué sur la vue détaillée A. Le tetra-babinet 100 selon l'invention permet ainsi d'augmenter la surface de la figure formée par les tâches, et ce faisant d'augmenter la qualité de la dépolarisation. Il permet en outre de conserver un déplacement de barycentre des tâches faible, et donc une erreur de pointage faible.

Dans un mode de réalisation préféré de l'invention, les prismes du tétra-babinet sont agencés de telle sorte que :

- l'angle $\alpha 1$ du premier prisme est égal à l'angle $\alpha 2$ du deuxième prisme,

- l'angle $\alpha 3$ du troisième prisme est égal à l'angle $\alpha 4$ du quatrième prisme, et

- le deuxième prisme de babinet a une rotation de 45° et le quatrième prisme de babinet a une rotation de -45°.

L'inventeur a en effet trouvé que la meilleure qualité de dépolarisation est obtenue pour $\alpha1=\alpha2$ et $\alpha3=\alpha4$, et pour des rotations $\beta2$ et $\beta4$ du deuxième et quatrième prisme de babinet de respectivement 45° et -45° (afin d'augmenter la surface de la figure formée par les taches élémentaires à rayon de cercle circonscrit constant). La suite de la description sera faite en référence à un tétra-babinet ayant une telle configuration d'angles à titre d'exemple non limitatif.

La figure 17 représente les 16 taches images élémentaires qui résultent de la traversée d'un tétra-babinet selon l'invention ayant les caractéristiques précitées, à savoir : $\alpha1=\alpha2$, $\alpha3=\alpha4$, une rotation du deuxième prisme de 45°, et une rotation du quatrième prisme de -45°.

Les énergies des points gris 160 sont égales, de même que celle des points noirs 162. Le barycentre se déplace sur le segment de droite 164 représenté. La figure 17 illustre la définition du rayon du cercle circonscrit aux 16 taches élémentaires et qui est représentée par le cercle 166 qui passe par les deux tâches les plus externes et qui a pour centre 0, le milieu du segment 164. Le rayon de ce cercle est assimilable au rayon de la tache image en sortie de dépolariseur ; ainsi plus il est important, plus la qualité d'image après le dépolariseur est faible.

Le tétra-babinet selon l'invention présente des avantages significatifs par rapport au double-babinet de l'art antérieur. En effet, le double-babinet de l'art antérieur n'offre que deux paramètres d'optimisation, à savoir la pupille et l'angle $\alpha=\alpha1=\alpha2$ des deux prismes de babinet. Le double-babinet présente en outre des limitations en termes d'encombrement (limite sur la pupille) et d'erreur de pointage (limite sur l'angle $\alpha$). Par ailleurs, l'angle de prisme $\alpha$ a un impact sur le rayon de la tache image (donc un impact sur la qualité image), celle-ci étant bien supérieure à l'erreur de pointage, et n'étant donc pas atteinte.

Le tetra-babinet selon l'invention offre quant à lui trois paramètres d'optimisation, à savoir la pupille, l'angle $\alpha1=\alpha2$, et l'angle $\alpha3=\alpha4$. S'il présente des limitations en termes d'encombrement liées à la limite sur la pupille, les limitations relatives à l'erreur de pointage portent sur l'angle $\alpha1=\alpha2$, tandis qu'il n'y a pas de limite sur l'angle $\alpha3=\alpha4$. Enfin, l'angle $\alpha3=\alpha4$ a un impact sur la taille du rayon de la tache image.

Dans une forme de réalisation particulière de l'invention donnée à titre d'exemple, on considère les caractéristiques suivantes :

- une pupille d'instrument fixée à 40mm pour des raisons de radiométrie (pupille = 40mm),
- une limite d'erreur de pointage de 60m au sol, soit un angle de prisme $\alpha_{max}$ =0.3°
- un rayon de la tache image projetée au sol de 500m, soit un angle de prisme maximal $\alpha_{max}$=2.5°.

Avec un double-babinet selon l'art antérieur, il est nécessaire de choisir un angle $\alpha1=\alpha2=0.3°$ et une pupille de 40mm. Avec ces paramètres à 1600 nm, le taux de polarisation maximum après la traversée du dépolariseur, (Transmission_max - Transmission_min)/(Transmission_max + Transmission_min), est de 13% (contre 100% initialement).

Avec le tétra-babinet 100 selon l'invention, pour les caractéristiques ci-dessus, on obtient alors un angle $\alpha1=\alpha2=0.3°$ pour les deux premiers prismes de babinet 11 et 12, et un angle $\alpha3=\alpha4=2.5°$ pour les 2 derniers prismes de babinet 13 et 14. A 1600 nm, le taux de polarisation après traversée du dépolariseur est par conséquent de 0.7% (résultat de simulation obtenu par tracé de 1 millions de rayons). Il en résulte donc un gain supérieur à l'ordre de grandeur.

Le tétra-babinet selon l'invention permet ainsi un gain sur la qualité de dépolarisation d'un facteur sensiblement égal à 10. Il en résulte des conséquences significatives sur le design complet du spectromètre. Avec un dépolariseur de qualité, le critère de polarisation du réseau, qui correspond au point le plus critique, est complètement relâché. Or, il constitue l'aspect essentiel du design de l'instrument : tout le spectromètre est construit autour d'un réseau fabricable et peu polarisant. Si la contrainte sur la polarisation du réseau est relâchée, de nombreux réseaux deviennent utilisables et il devient alors possible de construire une combinaison optique simple et efficace.

En outre, le surcoût lié à la fabrication d'un tétra-babinet selon l'invention est négligeable par rapport au double-babinet classique en comparaison des relâchements autorisés sur le design du réseau et de toute l'optique.

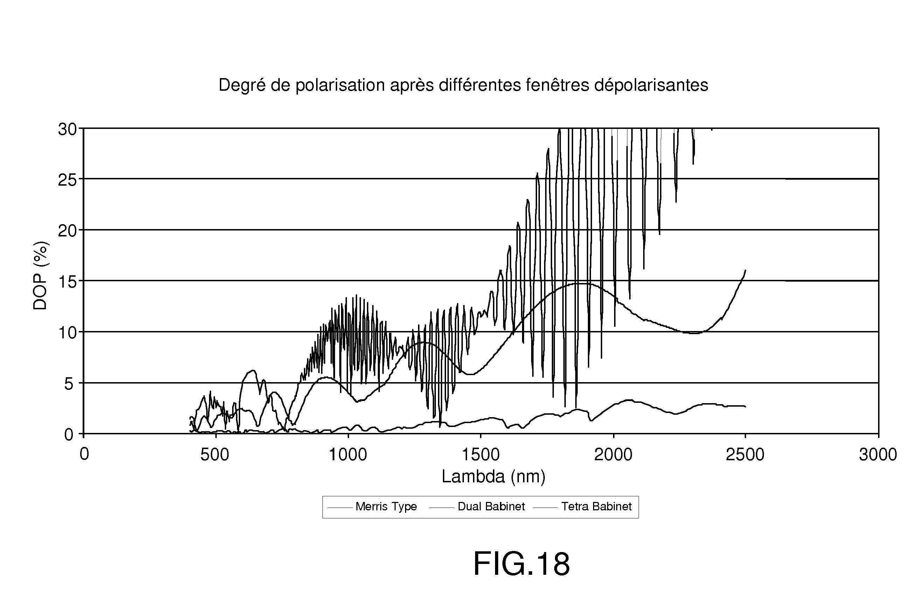

La figure 18 est un diagramme représentant le degré de polarisation pour un faisceau optique polarisé à 100% et traversant différents types de dépolariseurs. En particulier, cette figure illustre la performance d'un dépolariseur de type Meris (courbe notée M), d'un double-babinet (courbe notée DB) et d'un tétra-babinet selon l'invention (courbe notée TB) sur une large bande spectrale (400-2500nm). Les trois dépolariseurs ont la même pupille et la même erreur de pointage. Comme on peut le voir, le dépolariseur Meris (courbe M) est très sensible à la longueur d'onde et ne convient pas pour une large bande. Le double-babinet (courbe DB) présente des oscillations beaucoup plus lentes avec la longueur d'onde, mais ne fournit pas une dépolarisation suffisante sur toute la bande. Le tetra-babinet selon l'invention permet, quant à lui, de conserver un taux de polarisation inférieur à 3% sur toute la plage de longueur d'onde.

L'invention permet ainsi d'augmenter le nombre de degrés de liberté indépendants et d'optimiser les performances du dépolariseur. Le tétra-babinet permet en outre d'appliquer la contrainte d'erreur de pointage au premier prisme de babinet, et utilise les autres prismes pour l'amélioration de la dépolarisation.

Pour dimensionner le dépolariseur selon l'invention, les trois spécifications suivantes peuvent être utilisées :

- L'erreur de dépointage maximum acceptable ;

- Le diamètre du dépolariseur figé par la radiométrie ; et

- Le rayon de la tache image au sol qui représente la surface maximum balayée sur Terre.

L'erreur de dépointage permet de définir l'angle $\alpha1$ maximum acceptable (et donc l'angle au sommet du deuxième prisme $\alpha2=\alpha1$), selon la formule suivante :.

$$\alpha1 = asin(\theta / (2 * (n_e - n_o)),$$

où $\theta$ désigne l'erreur de pointage exprimée en radian, $n_e$ l'indice extraordinaire du matériaux biréfringent, à la longueur d'onde considérée et $n_o$ l'indice ordinaire.

Les angles aux sommets des troisième et quatrième prismes $\alpha3=\alpha4$ sont obtenus à partir du rayon de la tache image au sol, selon la formule suivante :

$$\alpha3 = asin(\varphi / (2 * (n_e - n_o))$$

où $\varphi$ représente le rayon de la tache image exprimée en radian, $n_e$ l'indice extraordinaire du matériaux biréfringent, à la longueur d'onde considérée et $n_o$ l'indice ordinaire.

Ces paramètres étant fixés, des simulations peuvent ensuite être lancées pour visualiser la performance de dépolarisation du tetra-babinet ainsi défini. En fonction des résultats de la simulation, il est possible de déterminer si les besoins sont satisfaits. Si les besoins ne sont pas satisfaits, il est alors possible soit d'augmenter le diamètre du dépolariseur, si l'augmentation du volume est acceptable, soit de négocier un relâchement des contraintes.

Bien que l'invention présente certains avantages pour un tétra-babinet ayant des angles $\alpha1=\alpha2$, $\alpha3=\alpha4$, une rotation de deuxième prisme de +45° et une rotation de troisième prisme de -45°, l'invention ne se limite pas à cette configuration.

En particulier, il est possible de prévoir une rotation du quatrième babinet de +45°, au lieu de -45°, avec les autres caractéristiques inchangées, à savoir $\alpha1=\alpha2$, $\alpha3=\alpha4$, et une rotation de deuxième prisme de +45°.

De manière générale, l'invention n'est pas limitée aux modes de réalisation décrits ci-avant à titre d'exemple non limitatif. Elle englobe toutes les variantes de réalisation qui pourront être envisagées par l'homme du métier. En particulier, le dépolariseur selon l'invention peut comporter un nombre pair de prismes de babinet ou équivalents supérieur à 4. Le choix d'un nombre pair permet de maximiser la surface de la figure formée par les tâches images (à rayon de PSF constant). En particulier, il pourrait être envisagé de prévoir un dépolariseur à 6 ou 8 babinets, selon l'invention.

Par ailleurs, il est possible d'appliquer à certains des 4 prismes une puissance non nulle pour améliorer encore la dépolarisation (en remplaçant par exemple le premier prisme du tetra-babinet par un prisme de puissance non nulle).

Le dépolariseur selon l'invention peut être utilisé pour dépolariser la lumière en entrée de spectromètres spatiaux d'observation de la Terre. Il est en général adapté pour dépolariser la lumière sur une large bande de longueur d'onde, de sorte qu'il peut être utilisé dans un spectromètre large bande. Toutefois, il n'est pas limité à ce type d'applications. En particulier, grâce à ses performances en matière de dépolarisation de la lumière, y compris sur des bandes de longueur d'onde étroite, il peut être utilisé dans tous type de spectromètre.

Le dépolariseur selon l'invention n'est pas non plus limité à une utilisation dans des spectromètres, et peut être utilisé dans tout instrument optique nécessitant un dépolariseur.

## Revendications

**1.** Dispositif de dépolarisation (100) pour réduire le degré de polarisation d'un faisceau incident **caractérisé en ce qu'**il comprend un ensemble de prismes (11, 12, 13, 14) comprenant un nombre pair de prismes au moins égal à 4, lesdits prismes étant agencés le long d'un axe optique principal, chaque prisme étant constitué de deux lames prismatiques élémentaires (111, 112, 121, 122, 131, 132, 141, 142) de matériaux biréfringents accolées dont les axes optiques sont orthogonaux entre eux, de manière à transformer le faisceau de lumière non polarisée qui le traverse en deux faisceaux de directions différentes et de polarisations linéaires orthogonales entre elles, chaque prisme ayant un angle au sommet $\alpha$ et un angle de rotation $\beta$ prédéfini par rapport à l'axe optique principal, et **en ce que** l'angle au sommet du premier prisme, l'angle au sommet du deuxième prisme, l'angle au sommet du troisième prisme et l'angle au sommet du quatrième prisme sont choisis de manière à optimiser les performances du dispositif de dépolarisation.

**2.** Dispositif de dépolarisation selon la revendication 1, **caractérisé en ce que** l'angle au sommet du premier prisme (11) est choisi de manière à minimiser l'erreur de pointage.

**3.** Dispositif de dépolarisation selon l'une des revendications précédentes, **caractérisé en ce que** l'angle au sommet du deuxième prisme (12) est choisi de manière à optimiser l'efficacité de dépolarisation.

**4.** Dispositif de dépolarisation selon l'une des revendications précédentes, **caractérisé en ce que** l'angle au sommet du troisième prisme (13) et l'angle au sommet du quatrième prisme (14) sont choisis de manière à optimiser l'efficacité de dépolarisation et la taille de la tache image formée à la sortie du dispositif de dépolarisation.

**5.** Dispositif de dépolarisation selon l'une des revendications précédentes, **caractérisé en ce que** les angles de rotation du premier prisme (11), du deuxième prisme (12) et du troisième prisme (13) sont choisis de manière à optimiser les performances de l'efficacité de dépolarisation.

**6.** Dispositif de dépolarisation selon l'une des revendications précédentes, **caractérisé en ce qu'**il comprend 4 prismes (11, 12, 13, 14) et **en ce que** chaque prisme est un prisme de babinet.

**7.** Dispositif de dépolarisation selon l'une des revendications précédentes, **caractérisé en ce qu'**il comprend 4 prismes (11, 12, 13, 14) et **en ce que** chaque prisme est un prisme de Wollastone.

**8.** Dispositif de dépolarisation selon l'une des revendications 6 et 7, **caractérisé en ce que** l'angle $\alpha$1 au sommet du premier prisme (11) est égal à l'angle $\alpha$2 au sommet du deuxième prisme (12), et l'angle $\alpha$3 au sommet du troisième prisme (13) est égal à l'angle $\alpha$4 au sommet du quatrième prisme (14).

**9.** Dispositif de dépolarisation selon la revendication 8, **caractérisé en ce que** le deuxième prisme (12) présente un angle de rotation de + 45° autourde l'axe optique principal et le quatrième prisme (14) présente une rotation de -45° autour de l'axeoptique principal.

**10.** Dispositif de dépolarisation selon la revendication 8, **caractérisé en ce que** le deuxième prisme (12) présente un angle de rotation de - 45° autourde l'axe optique principal et le quatrième prisme (14) présente une rotation de +45° autour de l'axe optique principal.

**11.** Dispositif de dépolarisation selon l'une des revendications précédentes, **caractérisé en ce qu'**une puissance non nulle est appliquée à certains au moins des prismes du dispositif de dépolarisation.

FIG.1

FIG.2

FIG.3

**FIG.4**

Position possible du
barycentre des taches

T₁ ⟷ T₂

Distance proportionnelle à
l'angle α entre les prismes

**FIG.5**

101  1  102  201  2  202  10

Polarisation
quelconque

α

Tournée de 45°

α

**FIG.6**

Rayon PSF

T₁  T₂

Position possible du
barycentre des taches

T₃  T₄

4  10  Téléscope  Collimateur  41  40

Erreur de
géolocalisation

Dépolarisateur  Fente  Prisme  Imageur

44  43  42

**FIG.7**

**FIG.8**

**FIG.9**

FIG.10

FIG.11

**FIG.12**

Babinet
**FIG.13**

Wollaston
**FIG.14**

11 Rotation de
Babinet 2

12 Rotation du groupe
de Babinet 3 & 4

13 Rotation de
Babinet 4

14

$\beta_1$

$\alpha_1$

-45° ou+45°

Détermine

Géolocalisation
(Taux polarisation)

$\beta_2$

$\alpha_2$

0° à 360°

(Taux polarisation)

$\beta_3$

$\alpha_3$

-45° ou+45°

Taux polarisation
Taille tache image

$\alpha_4$

Taux polarisation
Taille tache image

FIG.15

162   160   162   160

45°

162   -45°

162   160

162

0   Position possible du
barycentre (164)

Rayon PSF   162   160   162

160

162   160   162   160

166

FIG.17

FIG.16

EP 2 767 860 A1

Degré de polarisation après différentes fenêtres dépolarisantes

FIG.18

Europäisches
Patentamt

European
Patent Office

Office européen
des brevets

**RAPPORT DE RECHERCHE EUROPEENNE**

Numéro de la demande

EP 14 15 4468

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | Jérôme Caron ET AL: "Polarization scramblers in Earth observing spectrometers: lessons learned from Sentinel-4 and 5 phases A/B1", , 12 octobre 2012 (2012-10-12), XP055089515, Extrait de l'Internet: URL:http://congrex.nl/icso/2012/papers/FP_ICSO-139.pdf [extrait le 2013-11-21] * abrégé * * Sections I, II-B et II-E * ----- | 1-11 | INV. G02B27/28 G01J3/02 |
| A | MCGUIRE JR J P ET AL: "ANALYSIS OF SPATIAL PSEUDODEPOLARIZERS IN IMAGING SYSTEMS", OPTICAL ENGINEERING, SOC. OF PHOTO-OPTICAL INSTRUMENTATION ENGINEERS, BELLINGHAM, vol. 29, no. 12, 1 décembre 1990 (1990-12-01), pages 1478-1484, XP000169289, ISSN: 0091-3286, DOI: 10.1117/12.55756 * le document en entier * ----- | 1-11 | |
| A | EP 1 953 805 A1 (NIPPON KOGAKU KK [JP]) 6 août 2008 (2008-08-06) * figure 13 * * alinéa [0104] * ----- | 1-11 | DOMAINES TECHNIQUES RECHERCHES (IPC) G02B G01J |
| A | CN 102 183 848 A (UNIV JINAN) 14 septembre 2011 (2011-09-14) * figures 9,10 * ----- | 1-11 | |

Le présent rapport a été établi pour toutes les revendications

| Lieu de la recherche | Date d'achèvement de la recherche | Examinateur |
|---|---|---|
| Munich | 5 mai 2014 | Girardin, François |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

........................................................................
& : membre de la même famille, document correspondant

EPO FORM 1503 03.82 (P04C02)

**EP 2 767 860 A1**

**ANNEXE AU RAPPORT DE RECHERCHE EUROPEENNE
RELATIF A LA DEMANDE DE BREVET EUROPEEN NO.**　　　　EP 14 15 4468

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-05-2014

| Document brevet cité au rapport de recherche | Date de publication | Membre(s) de la famille de brevet(s) | Date de publication |
|---|---|---|---|
| EP 1953805　　A1 | 06-08-2008 | EP　　1953805 A1<br>JP　　5067162 B2<br>JP　2012182479 A<br>KR 20080066041 A<br>US 2009115989 A1<br>WO 2007055120 A1 | 06-08-2008<br>07-11-2012<br>20-09-2012<br>15-07-2008<br>07-05-2009<br>18-05-2007 |
| CN 102183848　A | 14-09-2011 | AUCUN | |

Pour tout renseignement concernant cette annexe : voir Journal Officiel de l'Office européen des brevets, No.12/82